(19) Europäisches Patentamt / European Patent Office / Office européen des brevets

(11) **EP 2 430 468 B1**

(12) **FASCICULE DE BREVET EUROPEEN**

(45) Date de publication et mention de la délivrance du brevet:
**07.08.2013 Bulletin 2013/32**

(21) Numéro de dépôt: **10721740.8**

(22) Date de dépôt: **10.05.2010**

(51) Int Cl.:
*G01R 31/12* *(2006.01)*    *G01R 31/06* *(2006.01)*

(86) Numéro de dépôt international:
**PCT/EP2010/056330**

(87) Numéro de publication internationale:
**WO 2010/130671 (18.11.2010 Gazette 2010/46)**

(54) **DISPOSITIF DE DÉTECTION DE DÉCHARGE PARTIELLE APTE A DÉTERMINER L'ORIGINE EXTÉRIEURE OU INTÉRIEURE D'UNE DÉCHARGE PARTIELLE ET PROCÉDÉ ASSOCIÉ**

EINRICHTUNG ZUR DETEKTION VON TEILENTLADUNG MIT DER FÄHIGKEIT ZUR BESTIMMUNG DES EXTERNEN ODER INTERNEN URSPRUNGS EINER TEILENTLADUNG UND DIESBEZÜGLICHES VERFAHREN

PARTIAL DISCHARGE DETECTION DEVICE CAPABLE OF DETERMINING THE EXTERNAL OR INTERNAL ORIGIN OF A PARTIAL DISCHARGE, AND ASSOCIATED METHOD

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **13.05.2009 FR 0953146**

(43) Date de publication de la demande:
**21.03.2012 Bulletin 2012/12**

(73) Titulaire: **ALSTOM Technology Ltd**
**5400 Baden (CH)**

(72) Inventeurs:
• **LUNA, Gilbert**
  **F-93420 Villepinte (FR)**
• **LOUISE, Sébastien**
  **F-94600 Choisy Le Roi (FR)**

(74) Mandataire: **Ilgart, Jean-Christophe**
**Brevalex**
**95, rue d'Amsterdam**
**75378 Paris Cedex 8 (FR)**

(56) Documents cités:
**EP-A1- 1 484 616    EP-A2- 1 593 981**
**JP-A- 3 239 971    US-B1- 6 297 642**
**US-B1- 6 313 640**

**Description**

Domaine technique et art antérieur

L'invention concerne un dispositif de détection de décharge partielle de dispositif électrique sous tension. Le dispositif de l'invention est apte à déterminer si une décharge partielle qui survient est intérieure ou extérieure au dispositif électrique sous tension.

L'invention concerne également un procédé de détection de décharge partielle de dispositif électrique sous tension qui est apte à déterminer si une décharge partielle qui survient est intérieure ou extérieure au dispositif électrique sous tension.

La mesure de décharges partielles lors des essais de réception en usine des transformateurs de puissance est un critère permettant de s'assurer du bon fonctionnement des transformateurs. Selon les conditions d'environnement du transformateur en essai, il arrive quelquefois que cette mesure soit très perturbée et, en conséquence, faussée par des sources de décharges extérieures. Ces conditions d'environnement sont décrites dans la norme CEI 60 270 (2000), annexe G, page 9.

Un problème technique à résoudre est de pouvoir déterminer si les décharges partielles que l'on mesure sur un transformateur sous tension ont pour origine des sources extérieures au transformateur ou le transformateur lui-même. Cette problématique est encore plus vraie lors d'essais sur site, car alors les perturbations extérieures sont plus difficilement maîtrisables.

Il existe différentes méthodes pour identifier l'origine des décharges partielles.

Par exemple, l'identification des décharges partielles extérieures peut se faire à l'aide d'un détecteur ultrasonique ou à l'aide d'une caméra ultra-violet. Pour les détecteurs ultra-soniques, un problème réside en ce que ceux-ci sont également sensibles à des bruits extérieurs autres que le bruit dû à des décharges partielles. En conséquence, la détection des décharges partielles à l'aide de sources ultra-soniques n'est pas fiable. En ce qui concerne les caméras ultra-violet, un problème réside en ce que les caméras ultra-violet ne permettent de localiser que des décharges partielles de type corona, c'est-à-dire par ionisation de l'air. Les décharges partielles ayant une autre origine ne peuvent pas être détectées comme, par exemple, les décharges partielles dues aux commutations d'éléments électroniques. Par ailleurs, l'équipement nécessaire avec les caméras ultra-violet présente un coût très élevé, ce qui est un autre inconvénient.

Il est également connu la détection de décharges partielles internes à des appareillages électriques à l'aide d'antennes UHF (UHF pour « Ultra Haute Fréquence ») placées à l'intérieur de ces appareillages. Le brevet US 5 804 972 intitulé « Partial-Discharge Measuring Device » divulgue ainsi un dispositif de détection de décharges partielles internes à un appareillage électrique qui utilise une antenne UHF installée dans l'appareillage. Les brevets US 6 323 655 et FR 2 851 852 divulguent également la détection de décharges partielles internes à l'aide d'une antenne UHF.

Un problème de la détection des décharges partielles telle que décrite dans les brevets US 5 804 972, US 6 323 655 et FR 2 851 852 réside en ce que, dans certaines circonstances, une décharge partielle peut être détectée alors même que cette décharge partielle n'est pas une décharge intérieure, mais une décharge extérieure. C'est le cas, par exemple, pour des décharges partielles extérieures de très forte intensité ou qui surviennent lors de commutations électriques d'organes électriques (commandes de moteur, mauvais contacts au niveau des charbons des moteurs ou alternostats).

L'invention concerne un dispositif et un procédé de détection de décharges partielles qui ne présentent pas cet inconvénient.

La demande de brevet EP 1 484 616 A1 et le brevet US 6 297 642 B1 sont également connus de l'art antérieur.

La demande de brevet EP 1 484 616 A1 divulgue une méthode de détection de décharges patielles et un système de diagnostic. Le brevet US 6 297 642 B1 divulgue un procédé de détection de décharge partielle.

Exposé de l'invention

L'invention concerne un dispositif de détection de décharge partielle de cuve d'appareillage électrique sous tension, le dispositif comprenant des moyens de détection placés au contact de l'appareillage électrique sous tension et aptes à détecter une décharge partielle qui survient à l'intérieur ou à l'extérieur de la cuve, caractérisé en ce qu'il comprend :

- une première chaîne de mesure UHF qui comprend un premier capteur UHF inséré en tout ou partie dans la cuve et qui délivre un signal UHF dès lors qu'une décharge partielle survient à l'intérieur ou à l'extérieur de la cuve,
- une deuxième chaîne de mesure UHF sensiblement identique à la première chaîne de mesure UHF et qui comprend un deuxième capteur UHF placé à distance de la cuve et qui délivre un signal UHF dès lors qu'une décharge partielle survient à l'extérieur de la cuve, et
- un système d'acquisition qui comprend :

  → Des moyens d'acquisition, sur une bande de fréquences, du bruit de fond BF1 délivré par la première chaîne de mesure UHF et du bruit de fond BF2 délivré par la deuxième chaîne de mesure,

  → Des moyens de recherche de front raide sur un premier signal UHF délivré par la première chaîne de mesure et sur un deuxième signal UHF délivré par la deuxième chaîne de mesure,

dès lors qu'une décharge partielle est détectée par les moyens de détection,

→ Des moyens de détermination d'une amplitude maximale du premier signal UHF et d'une amplitude maximale du deuxième signal UHF si un front raide est détecté sur le premier signal UHF et/ou le deuxième signal UHF,

→ Des moyens de détermination, dans la bande de fréquences, d'un premier rapport signal sur bruit R1 relatif au premier signal UHF et d'un second rapport signal sur bruit R2 relatif au deuxième signal UHF,

→ Des moyens de comparaison des rapports R1 et R2, et

→ Des moyens de calcul aptes à décider que la décharge partielle qui survient est intérieure ou extérieure à la cuve en fonction du résultat délivré par l'étape de comparaison.

L'invention concerne également un procédé de détection de décharge partielle de cuve d'appareillage électrique sous tension, le procédé comprenant une étape de détection d'une décharge partielle qui survient à l'intérieur ou à l'extérieur de la cuve à l'aide de moyens de détection au contact de l'appareillage électrique, caractérisé en ce qu'il comprend :

- une étape d'acquisition, sur une bande de fréquences, du bruit de fond BF1 délivré par une première chaîne de mesure UHF qui comprend un premier capteur UHF inséré en tout ou partie dans la cuve,

- une étape d'acquisition, sur la bande de fréquences, du bruit de fond BF2 délivré par une deuxième chaîne de mesure UHF sensiblement identique à la première chaîne de mesure et qui comprend un capteur placé à distance de la cuve,

- une étape de mesure d'un signal UHF à l'aide de la première chaîne de mesure dès lors qu'une décharge partielle survient à l'intérieur ou à l'extérieur de la cuve,

- une étape de mesure d'un signal UHF à l'aide de la deuxième chaîne de mesure dès lors qu'une décharge partielle survient à l'extérieur de la cuve, et

- une étape d'acquisition qui comprend :

    → une étape de recherche de front raide sur un premier signal UHF délivré par la première chaîne de mesure et sur un deuxième signal UHF délivré par la deuxième chaîne de mesure, dès lors qu'une décharge partielle est détectée par les moyens de mesure,

    → une étape de détermination d'une amplitude maximale A (UHF1) du premier signal UHF et d'une amplitude maximale A(UHF2) du deuxième signal UHF si un front raide est détecté sur le premier signal UHF et/ou le deuxième signal UHF,

    → une étape de détermination, dans la bande de fréquences, d'un premier rapport signal sur bruit R1 relatif au premier signal UHF et d'un second rapport signal sur bruit R2 relatif au deuxième signal UHF,

    → une étape de comparaison des rapports R1 et R2, et

    → une étape de calcul apte à décider que la décharge partielle qui survient est intérieure ou extérieure à la cuve en fonction du résultat délivré par l'étape de comparaison.

Selon une caractéristique supplémentaire de l'invention, les moyens de calcul aptes à décider que la décharge partielle qui survient est intérieure ou extérieure au dispositif sous tension comprennent des moyens de comparaison d'un premier instant auquel le premier signal UHF a été détecté et d'un second instant auquel le deuxième signal UHF a été détecté, la décharge partielle détectée étant considérée comme extérieure au dispositif sous tension si, lorsque le rapport R1/R2 est sensiblement compris entre 1,3 et 0,7, le premier instant est sensiblement égal au second instant. Par premier instant sensiblement égal au second instant, il faut entendre, par exemple, une différence de temps de 5 nanosecondes ou moins entre les deux instants.

Le système d'acquisition est, par exemple, un calculateur (ordinateur, micro-processeur, ...) ou un oscilloscope.

Le procédé de l'invention est avantageusement apte à distinguer, de manière sûre et fiable, l'origine interne ou externe d'une décharge partielle quelconque qui survient.

La bande de fréquences dans laquelle les détecteurs UHF détectent est, par exemple, la bande 200MHz-1000MHz.

Brève description des figures

D'autres caractéristiques et avantages de l'invention apparaîtront à la lumière de la description de modes réalisation préférentiels fait en référence aux figures jointes, parmi lesquelles :

- la figure 1-représente un premier mode de réalisation de dispositif de détection de décharge partielle selon une première variante de l'invention ;

- la figure 2 représente un deuxième mode de réalisation de dispositif de détection de décharge partielle de la première variante de l'invention ;

- la figure 3 représente un organigramme du procédé de détection de décharge partielle selon la première variante de l'invention ;

- la figure 4 représente un dispositif de détection de décharge partielle selon une deuxième variante de l'invention ;

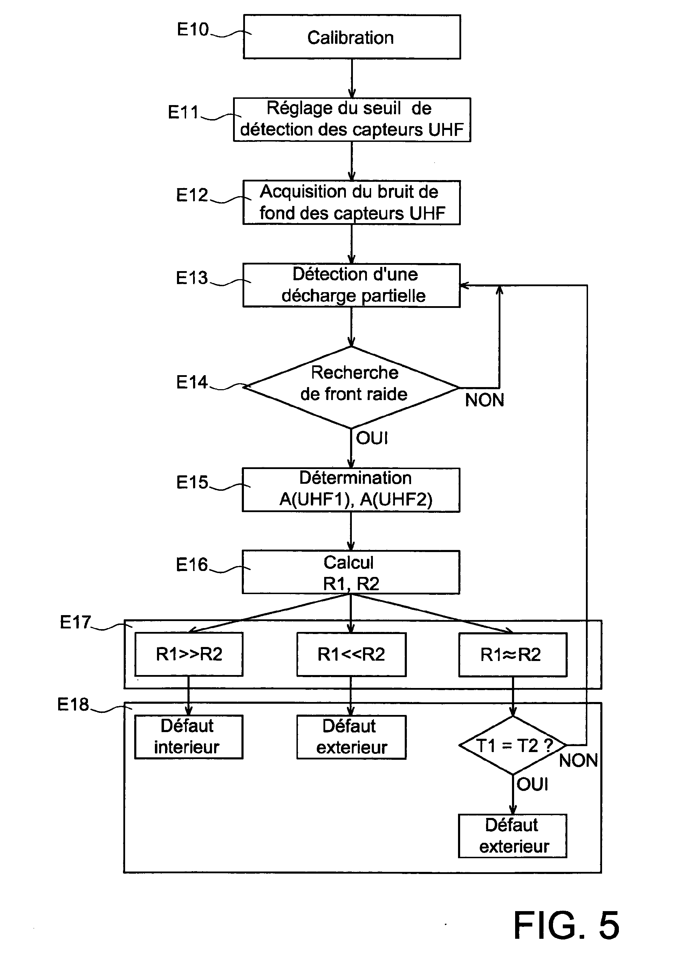

- la figure 5 représente un organigramme du procédé de détection de décharge partielle selon la deuxième variante de l'invention ;

- les figures 6A-6C représentent des courbes de mesure obtenues, par le procédé conforme à la première variante de l'invention, pour la détection d'une décharge partielle interne au dispositif ;
- les figures 7A-7C et 8A-8B représentent des courbes de mesure obtenues, par le procédé conforme à la première variante de l'invention, pour la détection d'une décharge partielle externe au dispositif.

Sur toutes les figures, les mêmes références désignent les mêmes éléments.

Exposé détaillé de modes de réalisation de l'invention

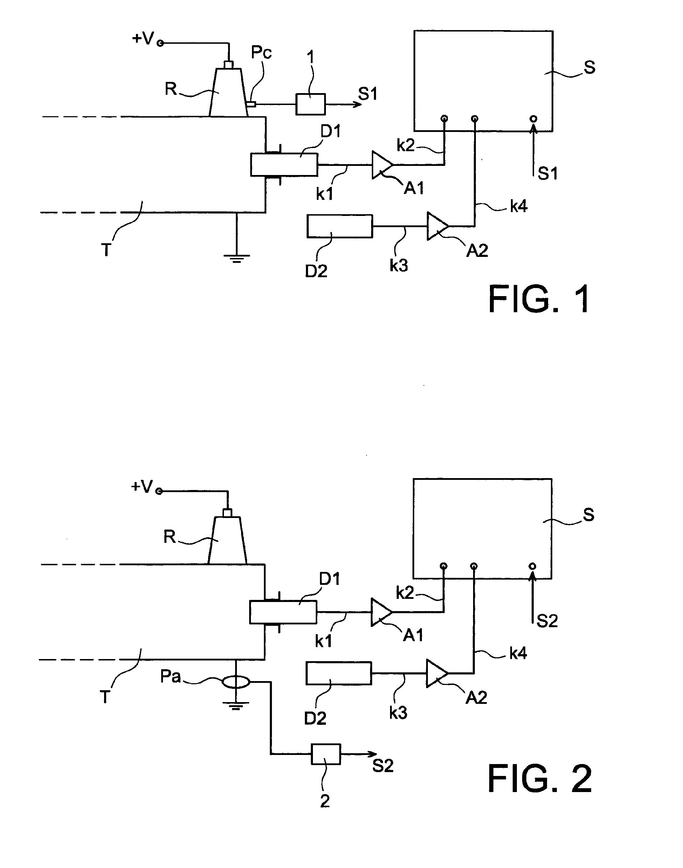

La figure 1 représente un premier mode de réalisation de dispositif de détection de décharge partielle selon une première variante de l'invention. Le dispositif électrique sous tension est, par exemple, une cuve de transformateur T sous tension +V.

Le dispositif comprend trois chaînes de mesure de décharge partielle et un système d'acquisition S. Une première chaîne de mesure comprend une prise capacitive de traversée Pc et un premier circuit 1 de mise en forme de signal en série avec la prise capacitive. La première chaîne de mesure est un moyen de mesure de décharge partielle conforme à la norme CEI 60270. La prise capacitive de traversée Pc prélève, de façon connue en soi, les signaux de décharge partielle au niveau d'une traversée R du transformateur T et le circuit 1 qui met en forme le signal prélevé par la prise capacitive délivre un signal S1 qui est transmis au système d'acquisition S. Une deuxième chaîne de mesure est constituée d'un capteur UHF D1, d'un préamplificateur A1 en série avec le capteur D1 et de câbles de connexion k1, k2, le câble k1 reliant le capteur D1 au préamplificateur A1 et le câble k2 reliant le préamplificateur A1 à la chaîne d'acquisition S. Le capteur D1 travaille, par exemple, dans la bande de fréquences [200MHz - 1000MHz]. Le capteur D1 est, par exemple, tel que celui décrit dans le brevet français N°2 851 852, c'est-à-dire une antenne formée de deux électrodes séparées par un résonateur diélectrique qui est placée dans une vanne de vidange du transformateur T, c'est-à-dire inséré dans une paroi de la cuve de transformateur. Le signal délivré par le capteur D1 est amplifié par le préamplificateur A1 et le signal délivré par le préamplificateur A1 est transmis à la chaîne d'acquisition S. La troisième chaîne de mesure comprend un capteur UHF D2, un préamplificateur A2 en série avec le capteur D2 et des câbles de connexion k3, k4, le câble k3 reliant le capteur D2 au préamplificateur A2 et le câble k4 reliant le préamplificateur A2 à la chaîne d'acquisition S. La troisième chaîne de mesure est sensiblement identique à la deuxième chaîne de mesure. Par chaînes de mesure « sensiblement identiques », il faut entendre des chaînes de mesure aptes à délivrer, au même instant et dans les mêmes conditions de mesure, deux signaux d'amplitudes sensiblement identiques suite à la détection de décharges partielles de même intensité. En particulier, les capteurs UHF D1 et D2 sont des capteurs identiques. La troisième chaîne de mesure est placée à distance de la cuve de transformateur.

Le système d'acquisition S est constitué de circuits qui déclenchent un traitement des mesures délivrées par les deuxième et troisième chaînes de mesure dès lors qu'une décharge partielle est détectée par la prise capacitive Pc (transmission d'un signal S1 au système d'acquisition S). Le système d'acquisition S est, par exemple, un oscilloscope.

La figure 2 représente un deuxième mode de réalisation de dispositif de détection de décharge partielle de la première variante de l'invention. Le dispositif comprend également trois chaînes de mesure de décharge partielle et un système d'acquisition S. Une première chaîne de mesure de décharge partielle comprend une pince ampèremétrique Pa haute fréquence large bande (par exemple, jusqu'à 100 MHz) et un circuit 2 de mise en forme du signal détecté par la pince ampèremétrique. Cette première chaîne de mesure est un moyen de mesure de décharge partielle conforme à la norme CEI 60270. La pince ampèremétrique Pa prélève, de façon connue en soi, les signaux de décharge sur un retour à la terre du transformateur (potentiel de référence du transformateur) et le circuit 2 qui met en forme le signal délivré par la prise ampèremétrique Pa délivre un signal S2 qui est transmis au système d'acquisition S. Les deux autres chaînes de mesure de décharge partielle sont identiques aux chaînes de mesure mentionnées pour le premier mode de réalisation. Elles sont positionnées de la même manière que décrit précédemment. La chaîne d'acquisition S est constituée de circuits de traitement qui déclenchent un traitement des mesures délivrées par les deuxième et troisième chaînes de mesure dès lors qu'une décharge partielle est détectée par la pince ampèremétrique Pa (transmission d'un signal S2 au système d'acquisition S). La chaîne d'acquisition S est, par exemple, un oscilloscope.

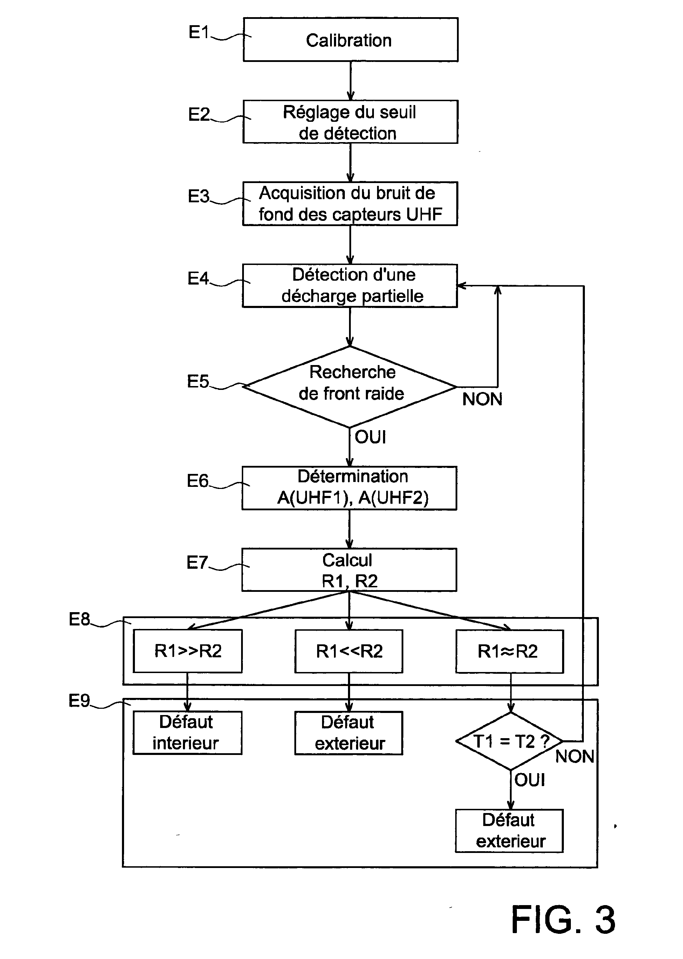

La figure 3 représente un organigramme du procédé de détection de décharge partielle selon la première variante de l'invention. Le procédé selon la première variante de l'invention est mis en oeuvre par l'un ou l'autre des dispositifs représentés en figure 1 et 2.

Le procédé comprend une étape E1 de calibration du dispositif de détection, une étape E2 de réglage du seuil de détection de la chaîne de mesure qui comprend le moyen de mesure conforme à la norme CEI 60270, une étape E3 d'acquisition par le système d'acquisition S, sur une bande de fréquences données, du bruit de fond délivré par les chaînes de mesure qui comprennent les capteurs UHF D1 et D2, une étape E4 de détection de décharge partielle par la chaîne de mesure qui comprend le moyen de mesure conforme à la norme CEI 60270 et, dès lors qu'une décharge partielle est détectée lors de l'étape E4, une étape E5 de recherche de front raide sur les signaux délivrés par les chaînes de mesure qui comprennent les capteurs UHF D1 et D2, une étape E6 de détermination de l'amplitude maximale de chacun des signaux détectés par les chaînes de mesure qui comprennent les capteurs UHF D1 et D2 si des fronts raides sont détectés lors de l'étape E5 sur l'un et/ou l'autre des signaux détectés par les chaînes de mesure qui comprennent les capteurs UHF D1 et D2, une étape E7 de calcul d'un premier rapport signal sur bruit R1 relatif au signal UHF détecté par le capteur D1 et d'un second rapport signal sur bruit R2 relatif au signal UHF détecté le capteur D2, une étape E8 de comparaison des deux rapports R1 et R2 et une étape E9 de décision qui détermine l'origine interne ou externe de la décharge partielle en fonction des résultats de la comparaison.

Lors de l'étape de calibration E1 un signal électrique calibré représentatif d'une décharge partielle selon la norme CEI 60 270 est injecté, de façon connue en soi, au niveau de la traversée R du transformateur sous tension. Le réglage du seuil de détection lors de l'étape E2 consiste à définir, de façon connue en soi, un niveau de signal au-dessus duquel une décharge partielle doit être prise en compte. L'étape E3 d'acquisition du bruit de fond consiste à mesurer, de façon connue en soi, le niveau de bruit détecté par les chaînes de mesure munies de capteurs UHF dans une bande de fréquences égale, par exemple, à [200MHz - 1000MHz]. Les bruits BF1 et BF2 mesurés, respectivement, sur la chaîne de mesure qui comprend le capteur UHF D1 et sur la chaîne de mesure qui comprend le capteur UHF D2 sont mis en mémoire dans le système d'acquisition S. Les étapes E2 et E3 peuvent être effectuées simultanément ou décalées dans le temps. Lorsque la chaîne de mesure qui comprend la prise capacitive Pc ou la pince ampèremétrique Pa détecte une décharge partielle (étape E4), l'étape E5 de recherche de front raide sur les signaux délivrés par les chaînes de mesure UHF est lancée. Un front raide matérialise l'apparition d'une décharge partielle. Ainsi, l'obtention d'un front raide lors de l'étape E5 confirme-t-elle l'apparition d'une telle décharge. La recherche de front raide s'effectue, de façon connue en soi, par exemple par le procédé décrit dans le brevet Français N°2 883 979 (« Procédé de détection de la position d'un front d'onde dans un signal reçu par un détecteur »). Si aucun front raide n'est détecté sur l'une des deux chaines de mesure UHF, il est considéré qu'aucune décharge partielle n'a été émise et le dispositif de détection est remis en attente d'une décharge partielle. Si, au contraire, un front raide est détecté sur l'une et/ou l'autre chaine de mesure UHF, l'étape E6 détermine l'amplitude maximale A(UHF1) du signal détecté par le capteur D1 et l'amplitude maximale A(UHF2) du signal détecté par le capteur D2. Ensuite, l'étape E7 calcule les rapports signal sur bruit R1 et R2 tels que :

$$R1 = A(UHF1) / BF1,$$

et

$$R2 = A(UHF2) / BF2.$$

Le rapport R1 ou R2 prend la valeur 1 si la chaîne de mesure UHF correspondante n'a pas détecté de signal de décharge partielle.

A l'étape E7 de calcul des grandeurs R1 et R2 succède l'étape E8 de comparaison des grandeurs R1 et R2. Différents cas se présentent qui peuvent se rassembler en trois possibilités :

- R1 >> R2 ;
- R2 >> R1 ;
- R1 # R2 (R1 # R2 correspond non seulement au cas où les rapports R1 et R2 sont sensiblement égaux, mais également au cas où leur rapport R1/R2 est compris dans une fourchette définie à l'avance, par exemple : 1,3 > R1/R2 > 0,7).

L'étape E9 de décision succède à l'étape E8 de comparaison. Dans le cas où R1 >> R2, c'est un défaut interne au dispositif qui est diagnostiqué et dans le cas où R2 >> R1, c'est un défaut externe qui est diagnostiqué. Dans le cas où R1 et R2 ne sont pas trop différents l'un de l'autre (par exemple : 1,3>R1/R2>0,7), un calcul complémentaire est effectué pour comparer les instants auxquels ont été détectés les signaux par les chaînes de mesure UHF. Si les instants T1 et T2 auxquels les capteurs D1 et D2 ont détecté les signaux sont quasi-identiques, il est diagnostiqué un défaut externe au transformateur. Sinon aucune décharge partielle n'est diagnostiquée et le dispositif de détection est remis en attente d'une décharge partielle. Par instants de détection « quasi-identiques », il faut entendre, par exemple deux instants séparés de 5 nanosecondes ou moins. Les étapes E5-E9 sont mises en oeuvre par le système d'acquisition S.

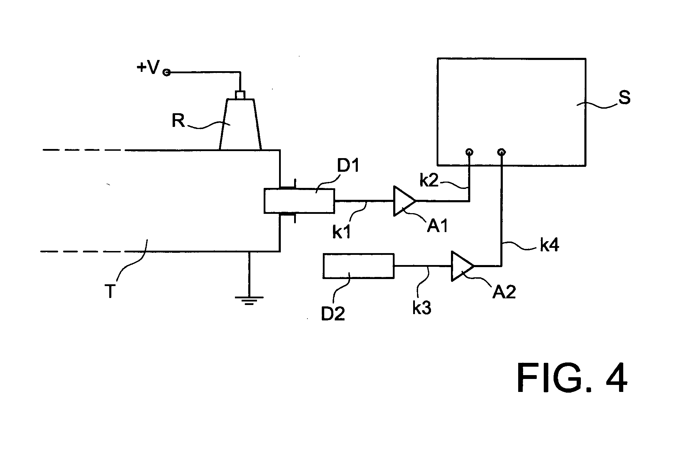

La figure 4 représente un dispositif de détection de décharge partielle selon la deuxième variante de l'invention.

Selon la deuxième variante de l'invention, le dispositif de détection de décharge partielle ne comprend que les deux chaînes de mesure UHF et le système d'acquisition S. Les décharges partielles ne sont alors plus détectées par un des moyens de mesure conformes à la norme CEI 60270 comme c'est le cas dans la première variante de l'invention, mais à l'aide de la chaîne de mesure UHF dont le capteur D1 est monté sur le transformateur. Le procédé de détection comprend ici une étape E10 de calibration du dispositif de détection, une étape E11 de réglage du seuil de détection des chaînes de mesure UHF, une étape E12 d'acquisition, sur une bande de fréquences donnée, du bruit de fond délivré par les chaînes de mesure UHF, une étape E13 de détection de décharge partielle par la chaîne de mesure UHF qui comprend le détecteur D1 et, dès lors qu'une décharge partielle est détectée lors de l'étape E13 une étape E14 de recherche de front raide sur les signaux délivrés par les deux chaînes de mesure UHF, une étape E15 de détermination de l'amplitude maximale de chacun des signaux détectés par les chaînes de mesure UHF si des fronts raides sont détectés, lors de l'étape E14, sur l'un et/ou l'autre des signaux détectés par les chaînes de mesure qui comprennent les capteurs UHF D1 et D2, une étape E16 de calcul d'un premier rapport signal sur bruit R1 relatif au signal UHF détecté par le capteur D1 et d'un second rapport signal sur bruit R2 relatif au signal UHF détecté par le capteur D2, une étape E17 de comparaison des deux rapports R1 et R2 et une étape E18 de décision qui détermine l'origine interne ou externe de la décharge partielle en fonction des résultats de la comparaison. L'étape E14 de recherche de front raide est ici déclenchée par le signal de détection de décharge partielle qui est délivré par le capteur UHF D1 qui est monté sur le transformateur.

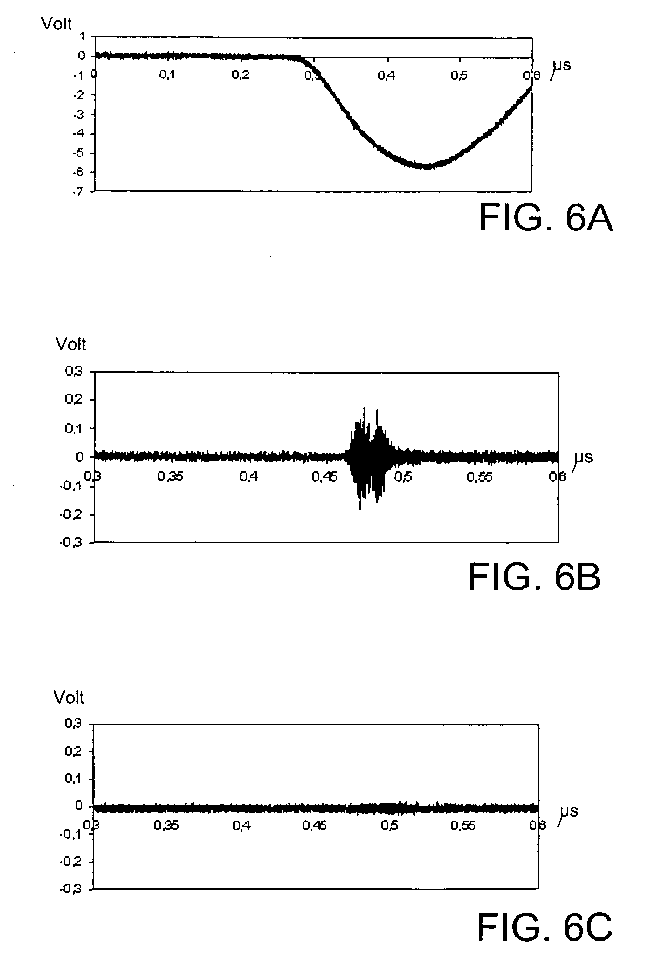

Les figures 6A-6C représentent, à titre d'exemple, des courbes de mesure en volt/$\mu$S obtenues par le procédé conforme à la première variante de l'invention, pour la détection d'une décharge partielle interne au dispositif électrique sous tension. La courbe 6A représente le signal mesuré par une prise capacitive Pc et les figures 6B et 6C représentent, respectivement, le signal mesuré par le capteur UHF D1 et le signal mesuré par le capteur UHF D2 (absence de signal). Dans ce cas, seul le capteur D1 détecte la décharge partielle, ce qui traduit l'origine interne de celle-ci.

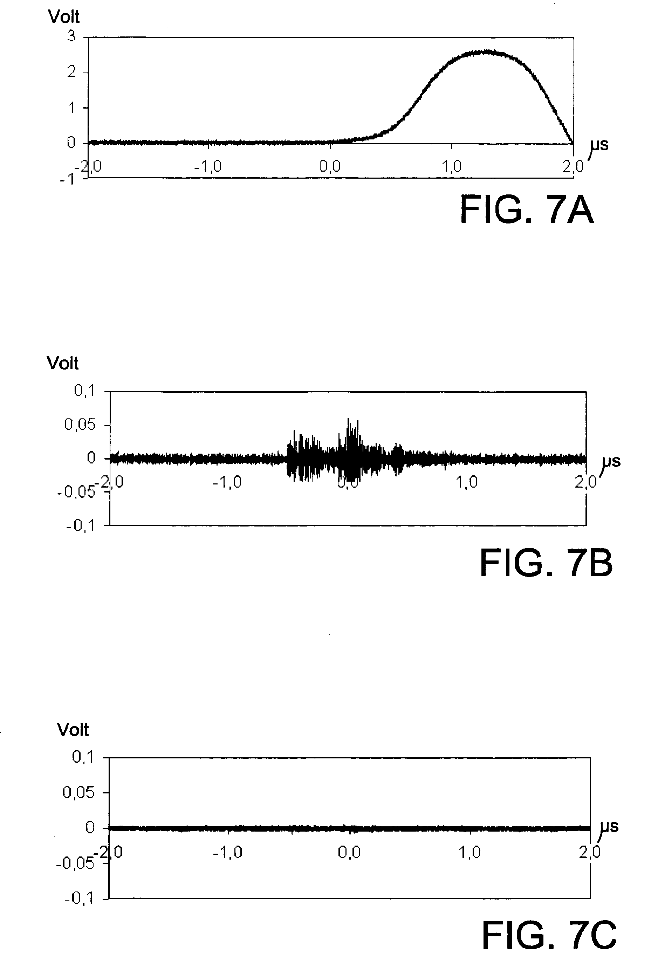

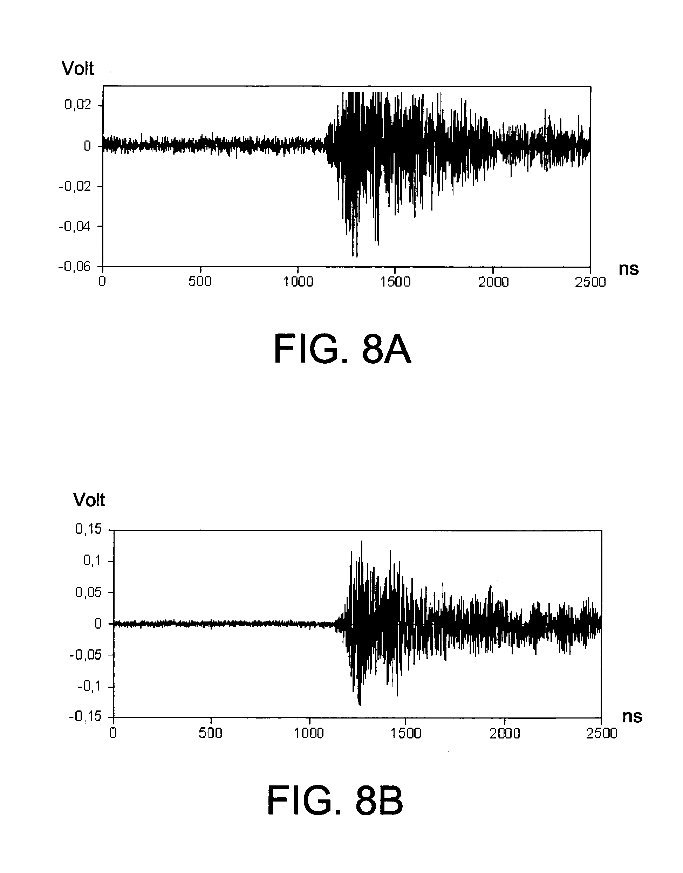

Les figures 7A-7C et 8A-8B représentent, à titre d'exemple, des courbes de mesure obtenues par le procédé conforme à la première variante de l'invention, pour la détection d'une décharge partielle externe au dispositif électrique sous tension. Les courbes des figures 7A-7C sont en volt/$\mu$S et les courbes des figures 8A-8B sont en volt/nS.

La figure 7A représente le signal mesuré par une prise capacitive Pc montée sur le dispositif électrique sous tension et les figures 7B et 7C représentent, respectivement, le signal mesuré par le capteur UHF D2 et le signal mesuré par le capteur UHF D1 (absence de signal). Dans ce cas, seul le capteur UHF D2 détecte la décharge partielle, ce qui traduit l'origine externe de celle-ci.

Les figures 8A et 8B représentent des signaux mesurés simultanément par les capteurs UHF D1 et D2. Dans ce cas, les deux capteurs UHF mesurent des signaux d'amplitudes sensiblement identiques détectés sensiblement au même instant.. Par signaux sensiblement détectés au même instant, il faut entendre des signaux dont les instants de détection respectifs T1 et T2 sont, par exemple, séparés de 5 nanosecondes ou moins. Le calcul des rapports signaux sur bruits R1 et R2 conduit alors à des valeurs sensiblement égales. Les instants T1 et T2 auxquels les signaux sont détectés sont alors comparés et, du fait de la quasi-simultanéité de ces instants, il en est déduit une origine externe de la décharge partielle.

## Revendications

1. Dispositif de détection de décharge partielle de cuve d'appareillage électrique sous tension (T), le dispositif comprenant des moyens de détection (Pc, Pa, D1) placés au contact de l'appareillage électrique sous tension (T) et aptes à détecter une décharge partielle qui survient à l'intérieur ou à l'extérieur de la cuve, et une première chaîne de mesure UHF (D1, A1) qui comprend un premier capteur UHF (D1) inséré en tout ou partie dans la cuve et qui délivre un signal UHF dès lors qu'une décharge partielle survient à l'intérieur ou à l'extérieur de la cuve, **caractérisé en ce que** le dispositif comprend, en outre :

   - une deuxième chaîne de mesure UHF (D2, A2) sensiblement identique à la première chaîne de mesure UHF et qui comprend un deuxième capteur UHF (D2) placé à distance de la cuve et qui délivre un signal UHF dès lors qu'une décharge partielle survient à l'extérieur de la cuve, et
   - un système d'acquisition (S) qui comprend :

      → Des moyens d'acquisition, sur une bande de fréquences, du bruit de fond BF1 délivré par la première chaîne de mesure UHF et du bruit de fond BF2 délivré par la deuxième chaîne de mesure,
      → Des moyens de recherche de front raide sur un premier signal UHF délivré par la première chaîne de mesure et sur un deuxième signal UHF délivré par la deuxième chaîne de mesure, dès lors qu'une décharge partielle est détectée par les moyens de détection,
      → Des moyens de détermination d'une amplitude maximale A (UHF1) du premier signal UHF et d'une amplitude maximale A (UHF2) du deuxième signal UHF si un front raide est détecté sur le premier signal UHF et/ou le deuxième signal UHF,
      → Des moyens de détermination (E3, E6, E7 ; E12, E15, E16), dans la bande de fréquences, d'un premier rapport signal sur bruit R1 et d'un second rapport signal sur bruit R2 tels que :

      $$R1 = A(UHF1)/BF1,$$

      $$R2 = A(UHF2)/BF2$$

→ Des moyens de comparaison (E8, E17) des rapports R1 et R2, et

→ Des moyens de calcul (E9, E18) aptes à décider que la décharge partielle qui survient est intérieure ou extérieure à la cuve en fonction du résultat délivré par l'étape de comparaison.

2. Dispositif selon la revendication 1, dans lequel la cuve est une cuve de transformateur sous tension et les moyens de détection montés sur le dispositif électrique sous tension pour détecter la décharge partielle qui survient sont constitués par un prise capacitive de traversée (Pc) qui prélève des signaux de décharge partielle au niveau d'une traversée (R) du transformateur.

3. Dispositif selon la revendication 1, dans lequel la cuve est une cuve de transformateur sous tension et les moyens de détection montés sur le dispositif électrique sous tension pour détecter la décharge partielle qui survient sont constitués par une pince ampèremétrique haute fréquence (Pa) qui prélève des signaux de décharge partielle sur un retour à la terre du transformateur.

4. Dispositif selon la revendication 1, dans lequel les moyens de détection au contact de l'appareillage électrique sous tension sont constitués par le premier capteur UHF (D1) de la première chaîne de mesure.

5. Dispositif selon l'une quelconque des revendications 1 à 4, dans lequel les moyens de calcul aptes à décider que la décharge partielle qui survient est intérieure ou extérieure au dispositif sous tension comprennent des moyens de comparaison d'un premier instant (T1) auquel le premier signal UHF a été détecté et d'un second instant (T2) auquel le deuxième signal UHF a été détecté, la décharge partielle détectée étant considérée comme extérieure au dispositif sous tension si, lorsque le rapport R1/R2 est sensiblement compris entre 1,3 et 0,7, le premier instant (T1) est sensiblement égal au second instant (T2).

6. Dispositif selon l'une quelconque des revendications précédentes, dans lequel la bande de fréquences est la bande 200MHz-1000MHz.

7. Dispositif selon l'une quelconque des revendications précédentes, dans lequel le premier capteur UHF (D1) et le deuxième capteur UHF (D2) sont, chacun, constitué d'une antenne électromagnétique formée par deux électrodes séparées par un résonateur diélectrique.

8. Procédé de détection de décharge partielle de cuve d'appareillage électrique sous tension, le procédé comprenant une étape de détection (E4, E13) d'une décharge partielle qui survient à l'intérieur ou à l'extérieur de la cuve à l'aide de moyens de détection au contact de l'appareillage électrique, et une étape d'acquisition, sur une bande de fréquences, du bruit de fond BF1 délivré par une première chaîne de mesure UHF qui comprend un premier capteur UHF inséré en tout ou partie dans la cuve, **caractérisé en ce qu'**il comprend, en outre :

- une étape d'acquisition, sur la bande de fréquences, du bruit de fond BF2 délivré par une deuxième chaîne de mesure UHF sensiblement identique à la première chaîne de mesure et qui comprend un capteur placé à distance de la cuve,
- une étape de mesure d'un signal UHF (E4, E13) à l'aide de la première chaîne de mesure dès lors qu'une décharge partielle survient à l'intérieur ou à l'extérieur de la cuve,
- une étape de mesure d'un signal UHF (E4, E13) à l'aide de la deuxième chaîne de mesure dès lors qu'une décharge partielle survient à l'extérieur de la cuve, et
- une étape d'acquisition (E5, E6, E7, E8, E9 ; E14, E15, E16, E17, E18) qui comprend :

→ une étape de recherche de front raide (E5, E14) sur un premier signal UHF délivré par la première chaîne de mesure et sur un deuxième signal UHF délivré par la deuxième chaîne de mesure, dès lors qu'une décharge partielle est détectée par les moyens de détection,

→ une étape de détermination d'une amplitude maximale A (UHF1) du premier signal UHF et d'une amplitude maximale A(UHF2) du deuxième signal UHF si un front raide est détecté sur le premier signal UHF et/ou le deuxième signal UHF,

→ une étape de détermination (E3, E6, E7 ; E12, E15, E16), dans la bande de fréquences, d'un premier rapport signal sur bruit R1 et d'un second rapport signal sur bruit R2tels que :

$$R1 = A(UHF1)/BF1,$$

$$R2 = A(UHF2)/BF2$$

→ une étape de comparaison (E8, E17) des rapports R1 et R2, et

→ une étape de calcul (E9, E18) apte à décider que la décharge partielle qui survient est intérieure ou extérieure à la cuve en fonction du résultat délivré par l'étape de comparaison.

9. Procédé selon la revendication 8, dans lequel l'étape de calcul (E9, E18) apte à décider que la décharge partielle qui survient est intérieure ou extérieure au dispositif électrique sous tension en fonction du résultat délivré par l'étape de comparaison consiste à comparer un premier instant (T1) auquel le premier signal UHF a été détecté avec un second instant (T2) auquel le deuxième signal UHF a été détecté, la décharge partielle détectée étant considérée comme extérieure au dispositif sous tension si, lorsque le rapport R1/R2 est sensiblement compris entre 1,3 et 0,7, le premier instant (T1) est sensiblement égal au second instant (T2).

**Patentansprüche**

1. Vorrichtung zur Erfassung einer Teilentladung eines Behälters eines unter Spannung (T) stehenden elektrischen Geräts, wobei die Vorrichtung Erfassungsmittel (Pc, Pa, D1) umfasst, die in Kontakt mit dem unter Spannung (T) stehenden elektrischen Gerät platziert und dazu ausgelegt sind, eine Teilentladung zu erfassen, die innerhalb oder außerhalb des Behälters auftritt, sowie eine erste UHF-Messkette (D1, A1), die einen ersten UHF-Sensor (D1) umfasst, der ganz oder teilweise in den Behälter eingesetzt ist und der ein UHF-Signal liefert, sobald innerhalb oder außerhalb des Behälters eine Teilentladung auftritt, **dadurch gekennzeichnet, dass** die Vorrichtung ferner umfasst:

   - eine zweite UHF-Messkette (D2, A2), die im Wesentlichen identisch zur ersten UHF-Messkette ist und die einen zweiten UHF-Sensor (D2) umfasst, der in einem Abstand von dem Behälter platziert ist und ein UHF-Signal liefert, sobald eine Teilentladung außerhalb des Behälters auftritt, und
   - ein Erfassungssystem (S) das umfasst:

      → Mittel zur Erfassung, über ein Frequenzband, des Hintergrundrauschens BF1, welches von der ersten UHF-Messkette geliefert wird, und des Hintergrundrauschens BF2, welches von der zweiten Messkette geliefert wird,
      → Mittel zur Suche nach einer steilen Flanke in einem ersten UHF-Signal, welches von der ersten Messkette geliefert wird, und in einem zweiten UHF-Signal, welches von der zweiten Messkette geliefert wird, sobald eine Teilentladung durch die Erfassungsmittel erfasst wird,
   → Mittel zur Bestimmung einer maximalen Amplitude A (UHF1) des ersten UHF-Signals und einer maximalen Amplitude A (UHF2) des zweiten UHF-Signals, wenn in dem ersten UHF-Signal und/oder in dem zweiten UHF-Signal eine steile Flanke erfasst wird,
   → Mittel zur Bestimmung (E3, E6, E7; E12, E15, E16), in dem Frequenzband, eines ersten Signal/Rausch-Verhältnisses R1 und eines zweiten Signal/Rausch-Verhältnisses R2 derart, dass:

$$R1 = A\,(UHF1)/BF1,$$

$$R2 = A\,(UHF2)/BF2$$

   → Mittel zum Vergleichen (E8, E17) der Verhältnisse R1 und R2, und
   → Rechenmittel (E9, E18), die dazu ausgelegt sind zu entscheiden, dass die Teilentladung, die auftritt, innerhalb oder außerhalb des Behälters ist, als Funktion des von der Vergleichsstufe gelieferten Ergebnisses.

2. Vorrichtung nach Anspruch 1, bei der der Behälter ein Transformatorbehälter unter Spannung ist, und die Erfassungsmittel, die an der unter Spannung stehenden elektrischen Vorrichtung angebracht sind, um die auftretende Teilentladung zu erfassen, durch einen kapazitiven Durchführungsstecker (Pc) gebildet sind, der Teilentladungssignale im Bereich einer Durchführung (R) des Transformators entnimmt.

3. Vorrichtung nach Anspruch 1, bei der der Behälter ein Transformatorbehälter unter Spannung ist, und die Erfassungsmittel, die an der unter Spannung stehenden elektrischen Vorrichtung angebracht sind, um die auftretende Teilentladung zu erfassen, durch eine Hochfrequenz-Strommessklemme (Pa) gebildet sind, die Teilentladungssignale an einer Rückführung zur Erde des Transformators entnimmt.

4. Vorrichtung nach Anspruch 1, bei der die Erfassungsmittel in Kontakt mit dem unter Spannung stehenden elektrischen Gerät durch den ersten UHF-Sensor (D1) der ersten Messkette gebildet sind.

5. Vorrichtung nach einem der Ansprüche 1 bis 4, bei der die Rechenmittel, die dazu ausgelegt sind zu entscheiden, dass die auftretende Teilentladung innerhalb oder außerhalb der unter Spannung stehenden Vorrichtung ist, Mittel umfassen zum Vergleichen eines ersten Zeitpunkts (T1), an dem das erste UHF-Signal erfasst worden ist, und eines zweiten Zeitpunkts (T2), an dem das zweite UHF-Signal erfasst worden ist, wobei die erfasste Teilentladung als außerhalb der unter Spannung stehenden Vorrichtung eingestuft wird, wenn der erste Zeitpunkt (T1) im Wesentlichen gleich dem zweiten Zeitpunkt (T2) ist, falls das Verhältnis R1/R2 im Wesentlichen zwischen 1,3 und 0,7 enthalten ist.

6. Vorrichtung nach einem der vorhergehenden Ansprüche, bei der das Frequenzband das Band 200 MHz - 1.000 MHz ist.

7. Vorrichtung nach einem der vorhergehenden Ansprüche, bei der der erste UHF-Sensor (D1) und der zweite UHF-Sensor (D2) jeweils durch eine elektromagnetische Antenne gebildet sind, die durch zwei Elektroden gebildet ist, welch durch einen dielektrischen Resonator getrennt sind.

8. Verfahren zur Erfassung einer Teilentladung eines Behälters eines unter Spannung stehenden elektrischen Geräts, wobei das Verfahren einen Schritt der Erfassung (E4, E13) einer Teilentladung umfasst, die innerhalb oder außerhalb des Behälters auftritt, mithilfe von Erfassungsmitteln im Kontakt mit dem elektrischen Gerät, sowie einen Schritt des Erfassens, in einem Frequenzband, von Hintergrundrauschen BF1, welches durch eine erste UHF-Messkette geliefert wird, die einen ersten UHF-Sensor umfasst, der ganz oder teilweise in den Behälter eingesetzt ist, **dadurch gekennzeichnet, dass** es ferner umfasst:

- einen Schritt der Erfassung, über das Frequenzband, von Hintergrundrauschen BF2, welches durch eine zweite UHF-Messkette geliefert wird, die im Wesentlichen identisch zur ersten Messkette ist und die einen Sensor umfasst, der in einem Abstand vom Behälter platziert ist,
- einen Schritt des Messens eines UHF-Signals (E4; E13) mithilfe der ersten Messkette, sobald eine Teilentladung innerhalb oder außerhalb des Behälters auftritt,
- einen Schritt des Messens eines UHF-Signals (E4, E13) mithilfe der zweiten Messkette, sobald eine Teilentladung außerhalb des Behälters auftritt, und
- einen Erfassungsschritt (E5, E6, E7, E8, E9; E14, E15, E16, E17, E18), der umfasst:

→ einen Schritt des Suchens nach einer steilen Flanke (E5, E14) in einem ersten UHF-Signal, welches von der ersten Messkette geliefert wird, und in einem zweiten UHF-Signal, welches von der zweiten Messkette geliefert wird, sobald eine Teilentladung durch die Erfassungsmittel erfasst wird,

→ einen Schritt des Bestimmens einer maximalen Amplitude A (UHF1) des ersten UHF-Signals und einer maximalen Amplitude A (UHF2) des zweiten UHF-Signals, wenn eine steile Flanke in dem ersten UHF-Signal und/oder dem zweiten UHF-Signal erfasst wird,

→ einen Schritt der Bestimmung (E3, E6, E7; E12, E15, E16), in dem Frequenzband, eines ersten Signal/Rausch-Verhältnisses R1 und eines zweiten Signal/Rausch-Verhältnisses R2 derart, dass:

$$R1 = A(UHF1)/BF1,$$

$$R2 = A(UHF2)/BF2$$

→ einen Schritt des Vergleichens (E8, E17) der Verhältnisse R1 und R2, und
→ einen Rechenschritt (E9, E18), der dazu ausgelegt ist zu entscheiden, dass die auftretende Teilentladung innerhalb oder außerhalb des Behälters ist, als Funktion des durch den Vergleichsschritt gelieferten Ergebnisses.

9. Verfahren nach Anspruch 8, bei dem der Rechenschritt (E9, E18), der dazu ausgelegt ist zu entscheiden, dass die auftretende Teilentladung innerhalb oder außerhalb der unter Spannung stehenden elektrischen Vorrichtung ist, und zwar als Funktion des durch den Vergleichsschritt gelieferten Ergebnisses, darin besteht, einen ersten Zeitpunkt (T1), an dem das erste UHF-Signal erfasst worden ist, mit einem zweiten Zeitpunkt (T2) zu vergleichen, an dem das zweite UHF-Signal erfasst worden ist, wobei die erfasste Teilentladung als außerhalb der Vorrichtung unter Spannung eingestuft wird, wenn der erste Zeitpunkt (T1) im Wesentlichen gleich dem zweiten Zeitpunkt (T2) ist, falls das Verhältnis R1/R2 im Wesentlichen zwischen 1,3 und 0,7 enthalten ist.

**Claims**

1. Detection apparatus for detecting a partial discharge from a live electrical equipment tank (T), the detection apparatus comprising detection means (Pc, Pa, D1) placed in contact with the live electrical equipment (T) and suitable for detecting the occurrence of a partial discharge that is internal or external relative to the tank, and a first UHF measurement system (D1, A1) that includes a first UHF sensor (D1) inserted completely or partly into the tank and that delivers a UHF signal whenever a partial discharge occurs that is internal or external relative to the tank, **characterized in that** the detection apparatus further comprises:

- a second UHF measurement system (D2, A2) that is substantially identical to the first UHF measurement system and that includes a second UHF sensor (D2) placed at a distance from the tank and that delivers a UHF signal whenever a partial discharge occurs that is external relative to the tank; and
- an acquisition system (S) that comprises:

- acquisition means for acquiring, in a frequency band, background noise BF1 delivered by the first UHF measurement system and background noise BF2 delivered by the second UHF measurement system;
- search means for seeking steep fronts in a first UHF signal delivered by the first measurement system and in a second UHF signal delivered by the second measurement system, whenever any partial discharge is detected by the detection means.
- determination means for determining a maximum amplitude A (UHF1) of the first UHF signal and a maximum amplitude A (UHF2) of the second UHF signal if a steep front is detected in the first UHF signal and/or the second UHF signal.
- determination means (E3, E6, E7; E12, E15, E16) for determining, in the frequency band, a first signal-to-noise ratio R1 and a second signal-to-noise ratio R2 such that:

$$R1 = A (UHF1) / BF1$$

$$R2 = A (UHF2) / BF2$$

- comparator means (E8, E17) for comparing the ratios R1 and R2; and
- computation means (E9, E18) suitable for deciding whether the detected partial discharge is internal or external relative to the tank, as a function of the result delivered by the comparison step.

2. Apparatus according to claim 1, wherein the tank is a tank of a live transformer, and the detection means mounted on the live electrical apparatus for the purpose of detecting a detected partial discharge are constituted by a bushing capacitive tap (Pc) that taps partial discharge signals at a bushing (R) of the transformer.

3. Apparatus according to claim 1, wherein the tank is a tank of a live transformer, and the detection means mounted on the live electrical apparatus for the purpose of detecting the detected partial discharge which occurs are constituted by a highfrequency clamp meter (Pa) that taps partial discharge signals from a grounding return of the transformer.

4. Apparatus according to claim 1, wherein the detection means in contact with the live electrical equipment are constituted by the first UHF sensor (D1) of the first measurement system.

5. Apparatus according to any one of claims 1 to 4, wherein the computation means suitable for deciding whether the detected partial discharge which occurs is internal or external relative to the live apparatus include comparator means for comparing a first instant (T1) at which the UHF signal was detected with a second instant (T2) at which the second UHF signal was detected, any partial discharge detected being considered as being external to the live apparatus if, when the ratio R1/R2 lies substantially in the range 1.3 to 0.7, the first instant (T1) is substantially equal to the second instant (T2).

6. Apparatus according to any preceding claim, wherein the frequency band is the band 200 MHz to 1000 MHz.

7. Apparatus according to any preceding claim, wherein the first UHF sensor (D1) and the second UHF sensor (D2) are each constituted by an electromagnetic antenna formed by electrodes separated by a dielectric resonator.

8. A detection method for detecting a partial discharge from a live electrical equipment tank, the method comprising a detection step (E4, E13) of detecting the occurrence of a partial discharge that is internal or external relative to the tank by means of detection means in contact with the electrical equipment and an acquisition step of acquiring, in a frequency band, background noise BF1 delivered by a first UHF measurement system that includes a first UHF sensor inserted completely or partly into the tank, **characterized in that** it further comprises:

- an acquisition step of acquiring, in the frequency band, background noise BF2 delivered by a second UHF measurement system that is substantially identical to the first measurement system and that includes a sensor placed at a distance from the tank;

- a measurement step of measuring a UHF signal (E4, E13) using the first measurement system whenever a partial discharge occurs that is internal or external relative to the tank;
- a measurement step of measuring a UHF signal (E4, E13) using the second measurement system whenever a partial discharge occurs that is external relative to the tank; and
- an acquisition step (E5, E6, E7, E8, E9; E14, E15, E16, E17, E18) that comprises:

- a search step of seeking steep fronts (E5, E14) in the first UHF signal delivered by the first measurement system and in a second UHF signal delivered by the second measurement system, whenever any partial discharge is detected by the measuring means;
- a determination step of determining a maximum amplitude A (UHF1) of the first UHF signal and a maximum amplitude A(UHF2) of the second UHF signal if a steep front is detected in the first UHF signal and/or the second UHF signal;
- a determination step (E3, E6, E7; E12, E15, E16) of determining, in the frequency band, a first signal-to-noise ratio R1 and a second signal-to-noise ratio R2 such that:

$$R1 = A \ (UHF1) \ / \ BF1$$

$$R2 = A \ (UHF2) \ / \ BF2$$

- a comparison step (E8, E17) of comparing the ratios R1 and R2; and
- a computation step (E9, E18) suitable for deciding whether the detected partial discharge is internal or external relative to the tank, as a function of the result delivered by the comparison step.

9. A method according to claim 8, wherein the computation step (E9, E18) suitable for deciding whether a detected partial discharge is internal to or external to the live electrical apparatus, as a function of the result delivered by the comparison step, consists in comparing a first instant (T1) at which the first UHF signal was detected with a second instant (T2) at which the second UHF signal was detected, the detected partial discharge being considered as being external to the live apparatus if, when the ratio R1/R2 lies substantially in the range 1.3 to 0.7, the first instant (T1) is substantially equal to the second instant (T2).

FIG. 1

FIG. 2

E1 — Calibration

E2 — Réglage du seuil de détection

E3 — Acquisition du bruit de fond des capteurs UHF

E4 — Détection d'une décharge partielle

E5 — Recherche de front raide — NON

OUI

E6 — Détermination A(UHF1), A(UHF2)

E7 — Calcul R1, R2

E8

| R1>>R2 | R1<<R2 | R1≈R2 |

E9

| Défaut interieur | Défaut exterieur | T1 = T2 ? — NON |

OUI

Défaut exterieur

# FIG. 3

FIG. 4

FIG. 5

FIG. 6A

FIG. 6B

FIG. 6C

FIG. 7A

FIG. 7B

FIG. 7C

FIG. 8A

FIG. 8B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5804972 A
- US 6323655 B
- FR 2851852
- EP 1484616 A1
- US 6297642 B1
- FR 2883979

**Littérature non-brevet citée dans la description**

- *CEI 60 270,* 2000, 9